# EUROPEAN PATENT APPLICATION

(11) **EP 1 313 001 A2**
(43) Date of publication of application: **21.05.2003**
(21) Application number: 02257601.1
(22) Date of filing: 01.11.2002
(51) Int. Cl.: G06F 3/00

(54) **Electronic test system**

(30) Priority: 14.11.2001 US 2859
(71) Applicant: Agilent Technologies, Inc., Palo Alto, CA 94306 (US)
(72) Inventor: Sutton, Christopher K., WA 98203 (US)
(74) Representative: Jehan, Robert

(57) **Abstract**

An electronic test system (100) with a tape recorder type graphical control interface (300, 400, 500, 600) that enables the user to control the execution of a test procedure. The control interface includes buttons (302 - 308) that enable the user to abort the execution of a test, pause the execution of a test, restart the test, restart a particular measurement in a test, skip a measurement in a test, or skip completely a test. The control interface is displayed on the graphical user interface as icons (301) or implemented as hardware where the control buttons are physical buttons (400, 500, 600) incorporated in an input device (514), an output device (406), or a remote control device (614).

## Description

The present invention relates to electronic systems for use, for example, in performing automated tests of complex electronic, electromechanical and mechanical equipment and products. The preferred embodiment provides an electronic test system with a graphical control interface that resembles that of a tape recorder to enable the user to efficiently control the execution of a test.

Test systems are used to check status and performance of complex electronic, electromechanical and mechanical products and equipment. Such tests can include validation tests which run through the various operations that the device under test (DUT) is capable of and records whether each operation was performed properly, environmental tests which expose the DUT to various combinations of temperature, pressure, and humidity, and records the results, production tests, etc. Generally, both the DUT and the systems providing the environmental and other constraints on the DUT are controlled electronically. In the last decade or so, computerized programs which are capable of controlling a variety of automated tests, referred to in the art as "test executive" programs, have been developed.

Test executive programs in the prior art include internal test executive programs developed by Agilent Technologies and TESTSTAND software developed by National Instruments Corporation, which is described as a ready-to-run test executive for organizing, controlling, and executing automated prototype, validation, or production test systems. The prior art Agilent Technologies programs did not use a graphical user interface (GUI); therefore, they did not allow the user to interact easily with the test software. The TESTSTAND software, while using a GUI, utilizes a conventional interface for a Windows™ program adapted to a test environment.

Tests usually are defined by a set of rules or specifications to which the DUT response is compared. The rules or specifications generally comprise various inputs defined by electrical and mechanical parameters applied to the DUT, such as voltage, current, specified manipulations of controls and device parts, as well as environmental parameters under which the test is conducted, such as temperature, humidity, pressure, and the time period over which a parameter is applied. Each test will include many combinations of the parameters applied to each element of the DUT, and often will be repeated many times. Thus, as equipment and products become more complex, electronic test programs have become very long and complex, often requiring several days, or even a week or more to run a complete test.

In prior art test systems, the control of the execution of the test is limited to the usual commands "Run Test" and "Abort Test". The user does not have simple means to command the test system to repeat a particular phase in the test without restarting the whole test program from the beginning or involving additional programming. As a result of starting from the beginning, the user wastes valuable time and valuable results.

The present invention seeks to provide improved testing.

According to an aspect of the present invention there is provided an electronic test system as specified in claim 1.

According to another aspect of the present invention there is provided a method of controlling the execution of an electronic test as specified in claim 9.

The preferred embodiment can provide a test executive system in which, at any given point in a lengthy test, the execution of a test can be controlled in a manner to change its course without additional programming steps or a waste of valuable time.

The preferred embodiment allows the user to control the execution of the entire procedure on a small, intuitive graphical display called a control interface. The control interface enables the user to quickly perform functions such as aborting or stopping the execution of a test, pausing the execution of a test, restarting the test, restarting a particular measurement in a test, skipping a measurement in a test, or skipping a test. The ability to control the execution of a test allows the user to save time by immediately taking action and modifying some of the elements of the execution process. The user is not constrained to wait to the end of the test procedure nor is the user constrained to completely abort the procedure in the event that a particular measurement has not performed properly according to a set of rules, or specifications, but instead can immediately take action to change the course of the test procedure. The preferred embodiment is easy to use and does not involve additional programming for executing the control commands.

The electronic test output is preferably displayed through an easy to use graphical user interface. It is divided into windows containing either icons for controlling the test procedure or windows for displaying the results of the test. The user can control the test procedure by accessing the programs represented by the icons and windows with a pointing device such as a mouse, a keyboard, a touch pad, a roller ball, or a joystick.

The portion of the display containing the control interface is preferably a small portion of the graphical user interface (GUI) where the control commands are displayed as icons. Preferably, the icons are displayed on a window as buttons. Preferably, the buttons have labels relating information on the function of each button.

The control interface allows the user to send instructions to the test procedure so that the test procedure responds to the commands by changing the course of the execution of the test procedure.

Preferably, each command is assigned to a single icon in such a manner that, when the user "clicks" on the icon using an input device, the test program responds accordingly.

Preferably, the command buttons are displayed as in a "tape recorder" wherein each button is assigned a recognizable and intuitive function, such as the functions used in a tape recorder or video cassette recorder (VCR), e.g., "play", "pause", "rewind", and "fast forward". The designs on the buttons are recognizable symbols for such "play", "pause", "rewind", and "fast forward" functions. Since most people in developed countries today are familiar with tape recorders, VCRs and CD-ROM players that utilize such interfaces, a typical user recognizes and is familiar with both the functions behind each symbol and the symbols.

Preferably, the test program has a hierarchical structure and the control interface permits the user to separately control different levels of the hierarchy. That is, the results are displayed in a multilevel structure having a highest level and one or more sublevels. Preferably, the levels of the hierarchy, starting from the highest level, are procedure, test, measurement, and datapoint. That is, the test procedure contains an ensemble of tests, each containing one or more measurements, and each measurement contains one or more datapoints. Preferably, the control interface allows the user to select the execution of the test program at a specific level in a test procedure. For example, the user can skip a particular test in the test procedure, therefore skipping dependent measurements and datapoints in the test. The user can also opt to skip a particular measurement in a specific test. Alternatively, the user can repeat a measurement in a test or repeat the execution of a specific test in a test procedure.

The preferred embodiment not only provides simple controls for the execution of an electronic test, but also displays the controls in an intuitive way.

An embodiment of the present invention is described below, by way of example only, with reference to the accompanying drawings, in which:
FIG. 1 is a block diagram showing the principal hardware components of the preferred embodiment of systems connected to a device under test;
FIG. 2 is a block diagram showing the hierarchical structure of the preferred embodiment of test program;
FIG. 3 shows a view of the graphical user interface of the electronic test system with an embodiment of control interface; and
FIGS. 4 through 6 show alternative embodiments of control interface.

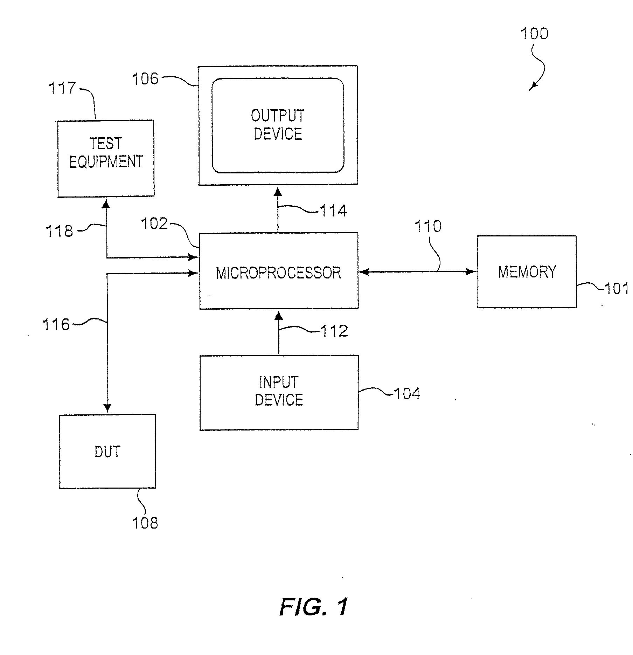

The described embodiment relates to an electronic test system with a control interface that enables the user to easily and intuitively control the execution of test programs. Referring to FIG. 1, in the preferred embodiment, the test system comprises a computer 100, including a memory 101, a microprocessor 102, an input device 104, and an output device 106. Memory 101 communicates with microprocessor 102 via electrical line 110. Input device 104 communicates with microprocessor 102 through electrical line 112. Microprocessor 102 outputs the data through output device 106 via electrical line 114.

In another embodiment, the test system can take the form of software stored in memory 101 and run or executed by processor 102. The user interacts with the test system through input device 104 such as, but not limited to, a keyboard, a mouse, a track ball, a touch pad, or a joystick. Input device 104 moves a cursor or a pointer on output device 106, which is a display system such as a cathode ray tube monitor or a liquid crystal display. The results of the test, as well as the control interface, are displayed on output device 106. The test is controlled by processor 102, which communicates the instructions of the test program to the product under test or device under test (DUT) 108 via electrical line 116. Processor 102 controls the test equipment 117 via electrical line 118. The test results are processed by processor 102 and stored in memory 101 to be visualized by display 106. The display information contains both information as to the configuration and position of the cursor and other visual information of interest to the user, such as the results of the test and other graphical elements for controlling the execution of the test procedure.

The system may be implemented in a variety of actual electronic devices that follow the general form outlined on FIG. 1. For example, the test system may be imbedded in a computer system, or it may also be imbedded in the hardware as a logic circuit, or embodied as an electronic testing device such as, but not limited to, an electronic analyzer.

In this embodiment, the electronic test system or electronic test program is stored in memory 101 to be managed and executed by processor 102. The electronic test system is a series of instructions that are executed by the processor via communication between memory 101, processor 102, and device under test 108, as well as transmission of commands between input device 104 and processor 102 via electrical line 112. The results, as well as the input parameters, are displayed as text and graphics on output device 106.

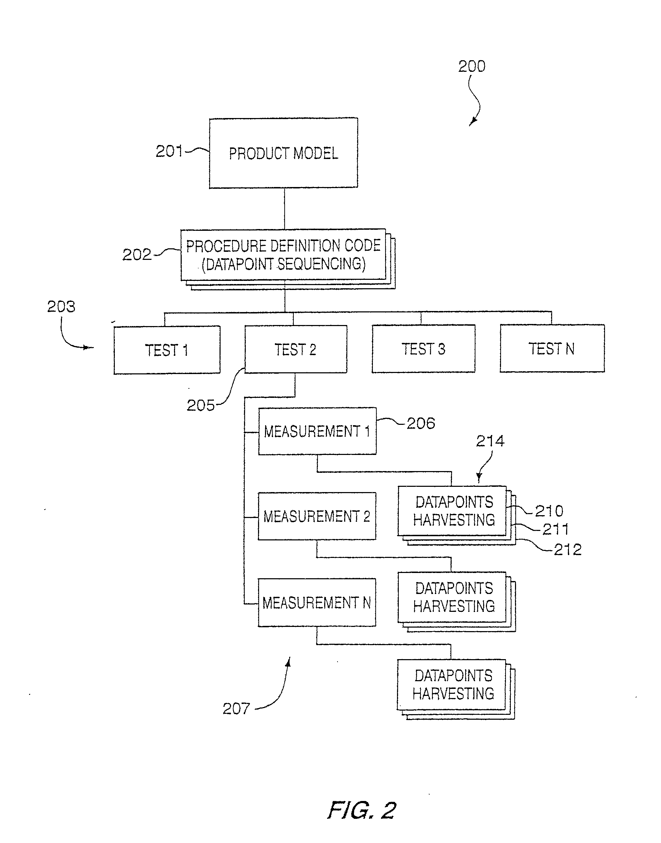

To better understand the workings of the preferred embodiment, it is helpful to describe the hierarchical structure of the preferred test program, and the order in which the test is performed. Referring to FIG. 2, there is shown a block diagram 200 illustrating the hierarchical, i.e., multi-level, characteristic of the test program. Herein, we shall refer to the broadest or most inclusive level as the "highest level" or "first level", though this choice is arbitrary. The first level 201 corresponds to the product model, a file the test developer creates to test a family of specific device model numbers. It contains test procedures and inputs.

The next level 202 corresponds to the procedure itself. A procedure is an ordered list, sequence, or script of tests to be run. Several procedures may exist, which is represented in FIG. 2 by a deck of cards 202, each representing a different procedure. Each procedure includes a plurality of tests, i.e., test 1, test 2, test 3 . . . test N, as shown at 203. Each test includes a plurality of measurements. This is illustrated in FIG. 2 for test 2 shown at 205. As shown, test 205 includes measurements 207, i.e., measurement 1, measurement 2 . . . measurement N. Each measurement includes one or more datapoints, each datapoint represented as one of the cards 210, 211, 212 in a stack of cards 214 associated with each measurement. A procedure is defined by writing a program or a code to build a structure of software objects. In one embodiment, the software objects are COM objects. COM is a language independent component architecture, not a programming language. It is meant to be a general purpose, object-oriented means to encapsulate commonly used functions and services. See Newton's Telecom Dictionary by Harry Newton, Publishers Group West, page 197.

A test 205 is a group of measurements 207 in a procedure 202 that share the same test algorithm or the same test software code. Some examples of tests include amplitude accuracy test, test of harmonic distortion, etc. The test program repeatedly calls a test for each measurement and datapoint.

A measurement, such as measurement 206, is a configuration or a setup for a test. Each measurement, in measurements 207, within a test 205 can have different setups or configuration parameters. Tests are parameter driven and the parameters are inputs at the measurement level. Measurements are elements such as range in volts, frequency in kilohertz or harmonic (an integer number). The test procedure 202 views measurements 207 as data to be passed from the procedure to a test. A measurement is also a phase of test execution. During the measurement phase of test execution, the measurement is started but data is not collected. This allows for multiple devices under test (DUTs) to be configured and triggered together.

A datapoint such as 210, 211, 212, is a subset of a measurement, such as 206, containing additional parameters that select a result when one measurement generates multiple results. Some examples of multiple datapoints for a measurement are the minimum and maximum of a spectrum analyzer sweep or each channel of a device.

For each datapoint, such as 210, in measurement 206, a value result is extracted. The results obtained are compared to specifications. Specifications are numerical limits, string match, or Boolean pass/fail. There are three sets of limits: marginal limits, line limits and customer limits. Each limit has an upper and a lower value.

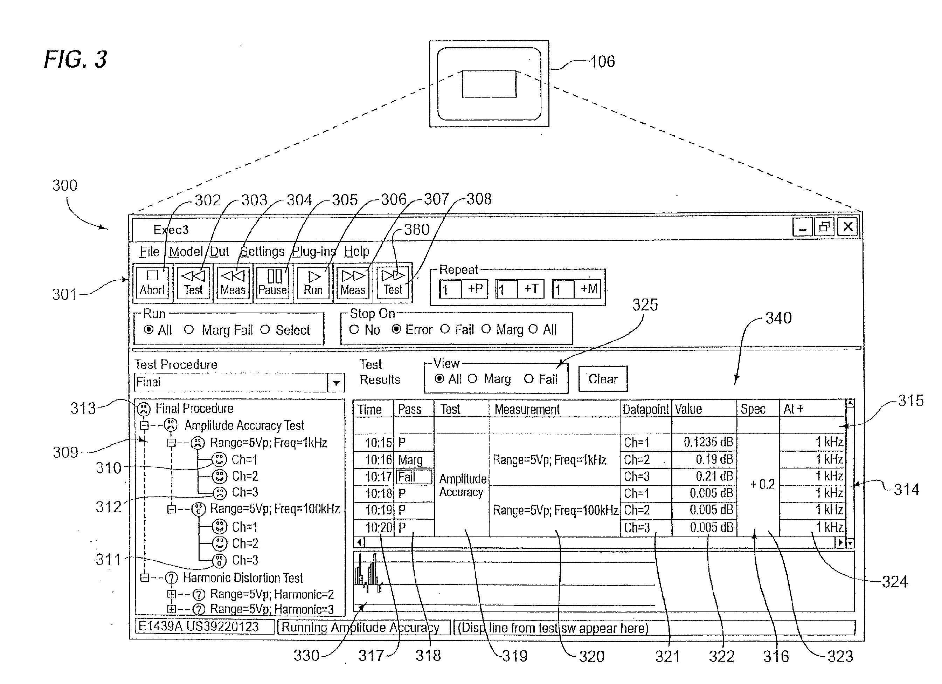

All the inputs and outputs of the electronic test system 100 (FIG. 1) are, preferably, handled through a graphical user interface. FIG. 3 shows a graphical user interface 300 comprising buttons 301 displayed on an output device 106. Each button has a graphical element, such as 380, associated with it that conveys a command for controlling test system 100. From left to right, the buttons control: abort 302, restart test 303, restart measurement 304, pause 305, run 306, skip measurement 307, skip test 308. Button 302 is used to abort the test procedure in case the user determines that the test is not running properly. Button 303 is used to restart a test. This is performed when the user determines that a specific test must be rerun. Button 304 is used to restart a measurement. This is performed when the user determines that a specific measurement is to be redone. Button 305 is used to momentarily stop the execution of a test procedure. This button is engaged in case the user wants to perform a task on the DUT or test system, for instance, checking a parameter or verifying various test settings, etc. Button 306 is used to start the test procedure. This button is activated to start the procedure or to restart the procedure after momentarily freezing the execution of the test procedure, i.e., after engaging "pause" button 305. Button 307 is activated when the user wishes to skip a specific measurement. Similarly, button 308 is activated when the user wishes to skip a particular test.

Buttons 303 or 304 can be engaged multiple times to back up the procedure execution by multiple tests or measurements, respectively. Buttons 307 or 308 can be engaged multiple times to skip multiple measurements or tests, respectively.

The bottom of the screen 309 shows a window describing the hierarchy of tests, measurements, and datapoints. Icons indicate pass, fail, marginal, and not yet tested. A "smiling" 310, "surprised" 311, and "sad" 312 icons correspond respectively to pass; marginal, and fail. The pass/fail icon 313 on top of the window is for the entire procedure. It summarizes the status of all the tests with the fail having priority. That is, if there is one fail test, the whole procedure is fail. The Boolean operator "AND" is used to compute the final status of the procedure.

The right side 314 of the graphical user interface 300 shows a window 340 comprising a series of rows, such as 315, and columns, such as 316. Window 340 displays the time 317 the test is run, as well as the status of the test 318. This window also displays the test that is being carried out, such as amplitude accuracy in 319, the type of measurement, such as (range=5Vp, Frequency=1kHz) in 320, the datapoint or channel under test, such as (Ch=1, Ch=2, Ch=3) in 321, the value or result of the measurement, such as (0.1235 dB) in 322, the specification, such as (" 0.2) in 323, and the frequency, such as (1kHz) in 324. The test can be sorted by clicking on the icon view on top of the window 325. This allows the test results to be filtered and displayed depending on their status. The bottom right window 330 is a progress window indicating the progress of the test procedure.

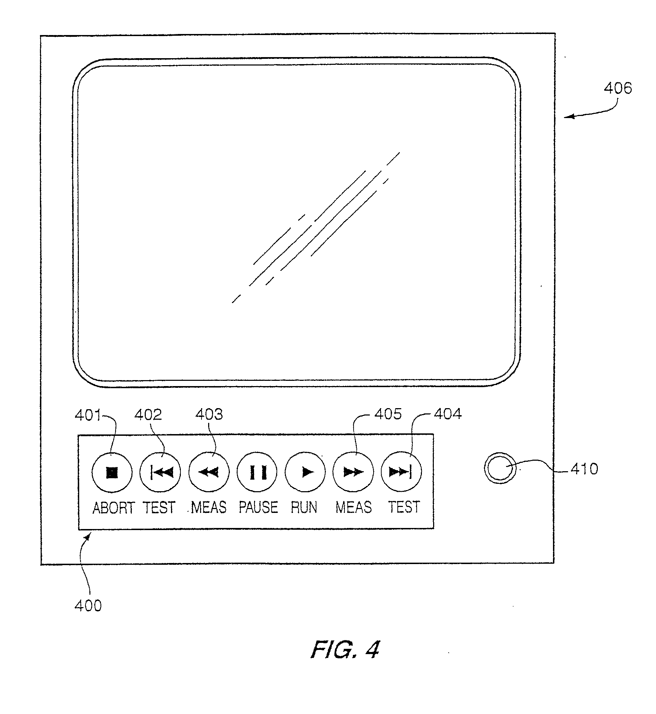

An alternative embodiment of control interface 400, is shown on FIG. 4. Referring to FIG. 4, the control interface is comprised of graphical elements that can take the form 400. The control interface 400 is imbedded as a series of physical buttons 401 - 404 on the lower part of output device 406 such as, but not limited to, a computer monitor. The control buttons, such as 401, 402, 403, are designed as round-buttons in this embodiment. To avoid confusion between restart test and restart measurement, different symbols are put on button 402 and button 403. Similarly, to avoid confusion between skip test and skip measurement, different symbols are put on button 404 and button 405. Button 410 represents the ON/OFF button of output device 106.

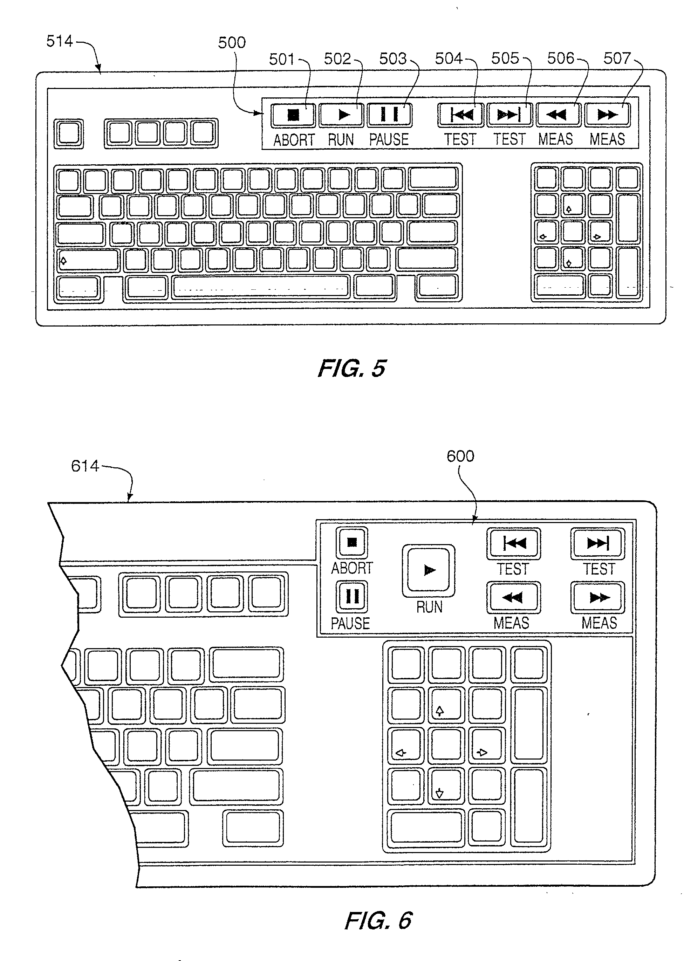

Other alternative embodiments of the control interface are shown in FIG. 5 and FIG. 6 where the different buttons are arranged in two different configurations 500 and 600 on input device 514 and 614, respectively, such as a keyboard. In configuration 500, shown in FIG. 5, the control buttons "abort" 501, "run" 502 and "pause" 503 are grouped together for easy access, since these buttons are more frequently used. The control buttons 504 "repeat test" and 505 "skip test" are grouped together for easy identification. Similarly, control buttons 506 "repeat measurement" and 507 "skip measurement" are also grouped together for easy identification. For example, in configuration 500, the control buttons can take the place of the "F" functions on a typical keyboard. FIG. 6 shows an alternative embodiment of the control interface where the control buttons are grouped in configuration 600. In this instance, the control buttons are designed and added to keyboard 614.

The different embodiments of the symbols used and grouping of the buttons on interfaces 400, 500, and 600, can, of course, be used in combination with an interface on a display, such as shown in FIG. 3, and the symbols and grouping shown on interface 300 in FIG. 3 can be used in combination with a monitor or keyboard. Other symbols and/or groupings may also be used.
Moreover, the control interface can be implemented on a remote control which resembles a remote control of a television or VCR, and any of the groupings and/or symbols may be used in combination with such a device.

It will be understood that the system can be embodied in other forms. For example, other systems may be implemented based on hardware or firmware instead of software, or the control interface may not be displayed on the graphical user interface but implemented as hardware, in which implementation the buttons are physical buttons.

The disclosures in United States patent application No. 10/002,859, from which this application claims priority, and in the abstract accompanying this application are incorporated herein by reference.

## Claims

1. An electronic test system (100) including: an electronic memory (101) storing steps for performing an electronic test on an electronic device under test (DUT) (108) that is separate and distinct from said test system; an electronic processor (102) communicating with said memory for controlling the execution of said electronic test; and a control interface (300, 400, 500, 600) communicating with said electronic processor, said control interface including at least four buttons (301) grouped adjacent one another; and a graphical element (380) associated with each of said buttons, each said graphical element conveying a command for controlling said test.

2. En electronic test system as in claim 1, wherein said commands include at least four of the following functions: run said test, pause said test, stop said test, skip said test, and restart said test.

3. An electronic test system as in claim 1, wherein said control interface includes a display (106) communicating with said electronic processor to display said buttons and said graphical elements; and an input device for interacting with said control interface and said processor to enable a user to control said test.

4. An electronic test system as in claims 1, 2 or 3, wherein said control interface includes icons grouped in the manner of a tape recorder.

5. An electronic test system as in any preceding claim, wherein said test stored in said memory has a hierarchical structure (200) including a plurality of levels and at least two of said buttons control the progress of said test at different ones of said levels.

6. An electronic test system as in claim 5, wherein said levels are test (203) and measurement (206).

7. An electronic test system as in claim 6, wherein there are two of said measurement buttons and said commands include the functions of skip said measurement and restart said measurement.

8. An electronic test system as in any preceding claim, wherein there are five of said buttons and five of said commands.

9. A method of controlling the execution of an electronic test including the steps of: providing an electronic test system (100) for performing an electronic test; utilizing said electronic test system to perform an electronic test on an electronic device under test (DUT) that is separate and distinct from said test system; displaying on said test system a control interface (301); and using an input device (104) to interact with said control interface to control the execution of said test; wherein said step of displaying a control interface includes displaying at least four tape recorder type control buttons grouped adjacent to one another.

10. A method as in claim 9, wherein said step of interacting includes at least four of the following steps: engaging an "abort" button to stop the execution of said test; engaging a "restart test" button to restart the execution of said test; engaging a "restart measurement" button to restart the execution of a measurement of said test; engaging a "pause" button to momentarily halt the execution of said test; engaging a "skip test" button to skip said test; engaging a "skip measurement" button to skip a measurement in said test; engaging a "repeat test" button to repeat said test; and engaging a "repeat measurement" button to repeat a measurement within said test.
